(19) **Europäisches Patentamt**
**European Patent Office**
**Office européen des brevets**

(11) **EP 4 475 379 A1**

(12) **EUROPEAN PATENT APPLICATION**

(43) Date of publication:
**11.12.2024 Bulletin 2024/50**

(21) Application number: **23183141.3**

(22) Date of filing: **03.07.2023**

(51) International Patent Classification (IPC):
*H02J 7/00* (2006.01)     *H02J 50/10* (2016.01)
*H01M 10/44* (2006.01)     *G01B 7/16* (2006.01)
*H02J 50/90* (2016.01)

(52) Cooperative Patent Classification (CPC):
**H02J 7/0047; G01B 7/22; H01M 10/445;**
**H02J 7/00719; H02J 50/10;** H02J 7/0029;
H02J 7/0042; H02J 50/90

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(30) Priority: **07.06.2023 US 202318331153**

(71) Applicant: **Aptiv Technologies AG**
**8200 Schaffhausen (CH)**

(72) Inventors:
• **Coon, Bradley Scott**
**Russiaville, IN, 46979 (US)**
• **Imboden, David Jerold**
**Kokomo, IN, 46902 (US)**

(74) Representative: **Manitz Finsterwald**
**Patent- und Rechtsanwaltspartnerschaft mbB**
**Martin-Greif-Strasse 1**
**80336 München (DE)**

(54) **CAPACITIVE SENSING FOR DETECTING BATTERY DEFORMATIONS**

(57) This document describes techniques for capacitive sensing to detect battery deformations during wireless charging of rechargeable batteries. An example system includes a processor that detects the placement of a mobile device with a rechargeable battery on a wireless charger. Before or during the charging session, the processor obtains capacitance values from multiple capacitive sensors integrated into or on the wireless charger. The processor analyzes the capacitance values and determines whether they indicate the deformation of the rechargeable battery, which may be caused by swelling or enlargement. In response to determining that the capacitance values indicate the deformation of the rechargeable battery, the processor does not initiate or terminates the charging session. In this way, the described techniques and systems can monitor for battery swelling and protect consumers and their mobile devices from the effects of battery swelling.

**EP 4 475 379 A1**

**Description**

**BACKGROUND**

Mobile devices (e.g., smartphones) with rechargeable batteries have become ubiquitous. The batteries, however, can swell and experience thermal runaway due to a build-up of internal gas (e.g., outgassing), especially during charging. The outgassing may be caused by various factors, including poor manufacturing, manufacturing defects in the battery cells, overcharging, deep discharging, physical damage, exposure to excessively high temperatures, or natural aging. The battery swelling may release hazardous and flammable gases, accelerate loss of battery capacity (and device run time), or damage the mobile device. Wireless charging systems, such as Qi® chargers and other inductive chargers, cannot detect battery deformations, thus putting battery cells and human safety at risk.

**SUMMARY**

This document describes techniques for capacitive sensing to detect battery deformations during wireless charging of rechargeable batteries in mobile devices (e.g., a smartphone). An example system includes a processor that detects the placement of a mobile device with a rechargeable battery on a wireless charger. Before initiating a charging session or during an active one, the processor obtains capacitance values from multiple capacitive sensors integrated into or on the wireless charger. The processor analyzes the capacitance values and determines whether they indicate the deformation of the rechargeable battery, which may be caused by swelling or enlargement. The swelling or enlargement often results in a variable distance or air gap between the surface of the wireless charger and the mobile device. In response to determining that the capacitance values indicate the deformation of the rechargeable battery, the processor does not initiate or terminates the charging session. In this way, the described techniques and systems can monitor for battery swelling and safeguard consumers and their devices.

This document also describes methods performed by the above-summarized system and other configurations set forth herein and computer-executable instructions and means for performing these methods.

This Summary introduces simplified concepts related to capacitive sensing for detecting battery deformations during wireless charging of rechargeable batteries described in the Detailed Description and Drawings. This Summary is not intended to identify essential features of the claimed subject matter, nor to determine the scope of the claimed subject matter.

**BRIEF DESCRIPTION OF THE DRAWINGS**

The details of one or more aspects of systems and techniques for capacitive sensing to detect battery deformations are described in this document with reference to the following figures. The same numbers are often used throughout the drawings to reference like features and components:

FIG. 1 illustrates an example environment in which capacitive sensing to detect battery deformations may be employed in accordance with techniques of this disclosure;

FIG. 2 illustrates an example configuration of a vehicle that includes systems for capacitive sensing to detect battery deformations during wireless charging;

FIGs. 3-1 through 3-3 illustrate an example wireless charger that performs capacitive sensing to detect battery deformations;

FIGs. 4-1 through 4-4 illustrate an example charging session in which capacitive sensing is used to detect a battery deformation in accordance with techniques of this disclosure;

FIGs. 5-1 and 5-2 illustrate an example flow chart for capacitive sensing to detect battery deformations during wireless charging; and

FIG. 6 illustrates an example method for capacitive sensing to detect battery deformations during wireless charging.

**DETAILED DESCRIPTION**

OVERVIEW

As described above, rechargeable batteries can swell and deform during charging. Such swelling may lead to the rechargeable battery exploding from the build-up of gases and thermal runaway or puncturing the rechargeable battery by other components within the consumer product, thus releasing hazardous and flammable gases. The swelling may also accelerate capacity loss and lead to the inability to achieve a full charge.

Some wireless charging systems may include diagnostics based on temperature or humidity sensors. However, these wireless charging systems do not monitor or detect battery deformation during charging. Because the warning systems that wireless chargers can provide are incomplete, rechargeable batteries and consumers are at risk during wireless charging of common, everyday consumer products (e.g., smartphones).

In contrast, this document describes techniques and systems for capacitive sensing to detect battery deformations during wireless charging. As one example, a wireless charging monitor detects the placement of a mobile device (e.g., a smartphone or other consumer product) with a rechargeable battery on a wireless charger. Before or during the charging session, the wireless charging monitor obtains capacitance values from multiple capacitive sensors integrated into or on the wireless charger. The wireless charging monitor analyzes the capacitance values and determines whether they indicate battery deformation. In response to determining that the capacitance values indicate battery deformation, the wireless charging monitor does not initiate or stops the charging session. In this way, the described techniques and systems can monitor for battery swelling and provide another layer to safeguard consumers and their devices, thus avoiding the potential destruction, hazards, and danger if the battery swelling progresses further.

This example is just one example of the described techniques and systems for capacitive sensing to detect battery deformations that can be used to control and manage the charging of rechargeable batteries or other energy storage devices. This document describes other examples and implementations.

WIRELESS CHARGER ENVIRONMENT

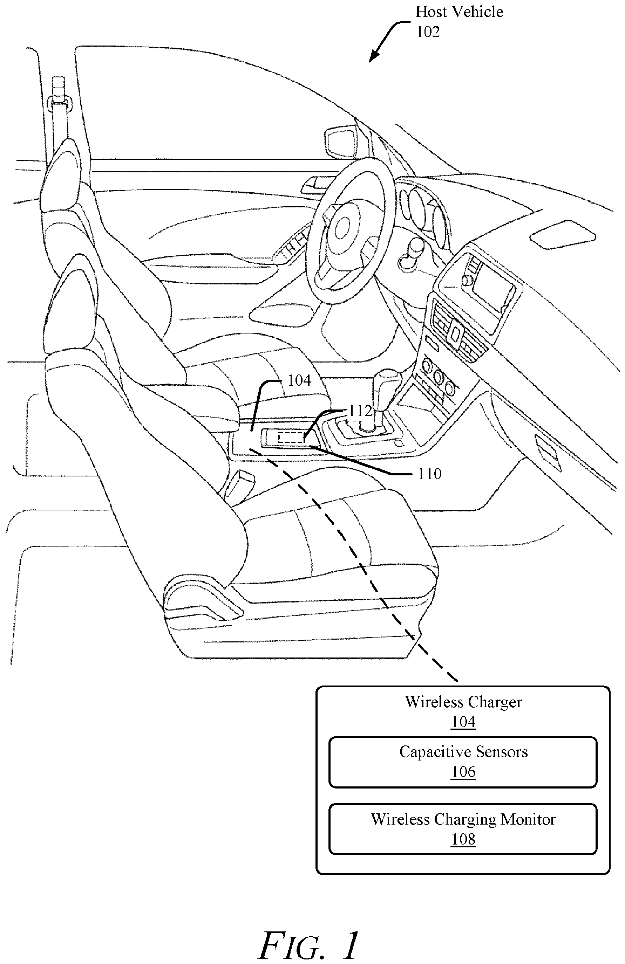

FIG. 1 illustrates an example environment in which capacitive sensing to detect battery deformations may be employed in accordance with techniques of this disclosure. FIG. 1 illustrates an interior of a host vehicle 102 that includes a wireless charger 104. The wireless charger 104 includes capacitive sensors 106 and a wireless charging monitor 108. A driver or passenger of the host vehicle 102 is charging a smartphone 110 on the wireless charger 104. The smartphone 110 includes a rechargeable battery 112.

The host vehicle 102 may be a motorized vehicle (e.g., a car, an automobile, a motorcycle, a passenger truck, a bus, a tractor, a semi-trailer truck), a watercraft (e.g., a boat), or an aircraft (e.g., an airplane) that includes the wireless charger 104. In other implementations, the wireless charger 104 may be located in a home, office, or other type of building. In such implementations, the wireless charger 104 may be a standalone product or integrated into another product (e.g., desktop organizer, nightstand). In other implementations, the smartphone 110 may be another type of mobile device or consumer product (e.g., a laptop, smartwatch, or tablet) with a rechargeable battery.

The rechargeable battery 112 is an energy storage device. For example, the rechargeable battery 112 may be a Lithium-ion battery used in a smartphone. The rechargeable battery 112 may also be another storage device (e.g., a battery associated with an airbag system or starter battery) in the host vehicle 102. The term "battery" or "energy storage device" may be used interchangeably in this document to refer to one or more electrochemical cells and other energy storage devices configured to provide electrical energy to a connected energy resource or load during discharge and accept and store electrical energy during charging from an energy source.

Rechargeable batteries, and other energy storage devices, are used in many personal, commercial, and automotive applications. These devices are available in various sizes and chemistries including, for example, Zinc-Carbon, Alkaline, Lead Acid, Nickel Cadmium, Nickel-Zinc, Nickel Metal Hydride, and Lithium-Ion. In addition, batteries usually must perform in a variety of conditions, including severe environments (e.g., with extreme temperatures). Common applications include computers, medical devices, communication devices, data centers, aircraft, hybrid vehicles, and electric vehicles.

The wireless charger 104 may for example be a Qi® wireless charger or another inductive charger. The Qi® standard is an interface standard for wireless power transfer using inductive charging, which allows compatible consumer products, such as the smartphone 110, to charge their batteries (e.g., the rechargeable battery 112) when placed on a Qi® charging pad. In other implementations, the wireless charger 104 may be another type of wireless charger.

The wireless charger 104 includes multiple capacitive sensors 106 to obtain measurements of the capacitance between each sensor electrode and the rechargeable battery 112 or the product containing the rechargeable battery 112 (e.g., the smartphone 110). The capacitive sensors 106 may be arranged in a horizontal array, a vertical array, or a combination thereof in a layer of the wireless charger 104.

The wireless charging monitor 108 reads or obtains measurements from the capacitive sensors 106 and determines whether the capacitance values or changes in the capacitance values over time indicate deformation of the rechargeable battery 112. For example, when the smartphone 110 without battery deformation is placed on the wireless charger 104, the capacitance measurements are generally consistent or near uniform across the capacitive sensors 106 because both the smartphone surface and the array surface are flat. The capacitance measurements may have typical steady-state values expected for a device without any battery deformation (e.g., saved profiles). However, if the rechargeable battery 112 is deformed, the smartphone surface becomes rounded, resulting in much lower capacitance measurements measured at the capacitive sensors 106 located under or near the rounding. The capacitance measurements veer too far from the steady state values set when no deformation occurs. As described in greater detail below, the decreased capacitance results from an air gap formed between the smartphone 110 and the top surface of the wireless charger 104. Air has a much lower dielectric constant than plastic, causing the capacitance measurements resulting from the dielectric stack of plastic-air-plastic to be measurably lower than the capacitance resulting from the stack of plastic-on-plastic.

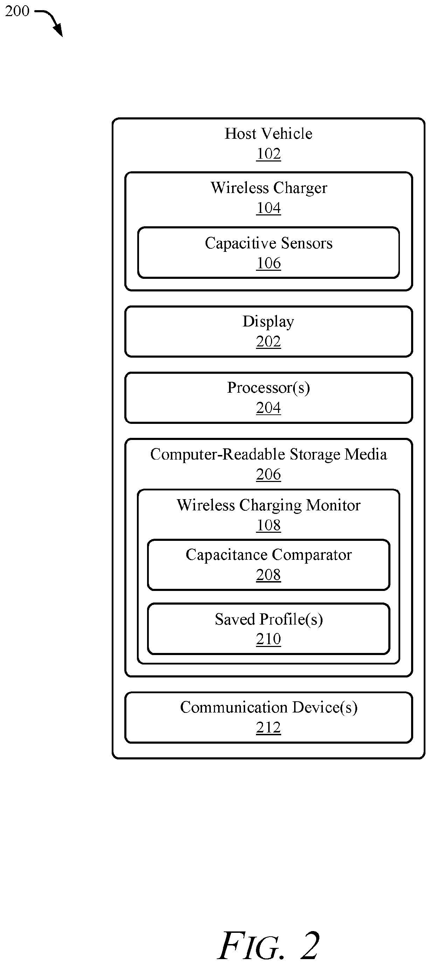

FIG. 2 illustrates an example configuration 200 of the host vehicle 102 that includes systems for capacitive sensing to detect battery deformations during wireless charging. The battery deformation is one indicator of a compromised or failing rechargeable battery 112. The host vehicle 102 may include the wireless charger 104, a display 202, one or more processors 204, computer-readable storage media (CRM) 206, and one or more communication devices 212. The host vehicle 102 also includes the wireless charging monitor 108. As illustrated in FIG. 1, the driver may use the wireless charger 104 to charge the rechargeable battery 112 of their smartphone 110 or other mobile devices.

As described in greater detail below, the wireless charger 104 uses an array or arrays of capacitive sensors 106 to detect changes in the surface geometry of the smartphone 110 or the rechargeable battery 112 (e.g., from flat to rounded or bowed) by measuring changes in capacitance between the sensor electrode of one or more capacitive sensors 106 and the rechargeable battery 112 (or the mobile device containing it). A similar approach can be used with rechargeable batteries that include cylindrical cells, packs of cylindrical cells, or prismatic cells. The capacitive sensors 106 occasionally (e.g., periodically) collect capacitance values associated with the rechargeable battery 112 before or during a charging session to detect battery deformation. The capacitance values are provided to the wireless charging monitor 108.

The display 202 may output graphical information to provide the driver or a passenger with the status regarding the charging session. Information may be output including a notification that a potential battery deformation was detected. In addition, the wireless charging monitor 108 can notify the driver that a previous charging error was detected for the particular mobile device (e.g., the smartphone 110) and ask the user whether to initiate or continue the current charging session. For example, the display 202 can be integrated into a center console or dashboard of the host vehicle 102.

The processors 204 (e.g., energy processing units, electronic control units, or microcontrollers) may be a microprocessor or a system-on-chip. The processors 204 execute instructions stored in the CRM 206, on one or more disks, memories, or other non-transitory computer-readable storage media. For example, processors 204 process measurement values from the capacitive sensors 106 and execute instructions loaded from the CRM 206 that cause the processors 204 to monitor the capacitance values associated with the rechargeable battery 112 and determine whether battery deformation has occurred.

The wireless charging monitor 108 can be stored in the CRM 206. The wireless charging monitor 108 may include a capacitance comparator 208 and one or more saved profiles 210. The capacitance comparator 208 periodically analyzes the capacitance values from the capacitive sensors 106 to determine whether battery deformation has occurred. As described below, battery deformation may be indicated by a large variance or standard deviation in the capacitance values, the average capacitance value being lower than a predetermined threshold or previous capacitance averages, or individual capacitance values (e.g., the minimum value) being lower than a threshold value.

The saved profiles 210 can also be stored in the CRM 206 or another CRM. The wireless charging monitor 108 can log or index the capacitance values for individual mobile devices (e.g., the smartphone 110) to assist in the analysis performed by the capacitance comparator 208. The saved profiles 210 may also include previous charging errors for a particular device so that the wireless charging monitor 108 can provide an indication or alert to the user on the display 202 or the smartphone's display and ask for input from the user whether to initiate or continue the charging session. The saved profiles 210 may also include default profiles for popular models and types of mobile devices to assist in detecting battery deformation during a first charging session for a particular device on the wireless charger 104. The saved profiles 210 may also include a knowledge of the age of each index or entry therein, which may be continually updated with new entries throughout the battery's life.

The communication devices 212 may include a sensor interface and a vehicle-based system interface. The sensor interface and the vehicle-based system interface transmit data (e.g., capacitance values, charging errors) over a communication bus of the host vehicle 102, for example, when the individual components of the wireless charger 104 and the wireless charging monitor 108 are integrated within the host vehicle 102. The communication devices 212 may also facilitate the exchange of data, including charging errors and driver input, over a wireless link between a remote system (e.g., the consumer product) and the host vehicle 102. The communication devices 212 may include hardware, software, and/or firmware required to communicate via Wi-Fi, wireless local area networks (WLANs), Dedicated Short-Range Communication, Bluetooth®, Vehicle-to-Everything (V2X), or cellular communication.

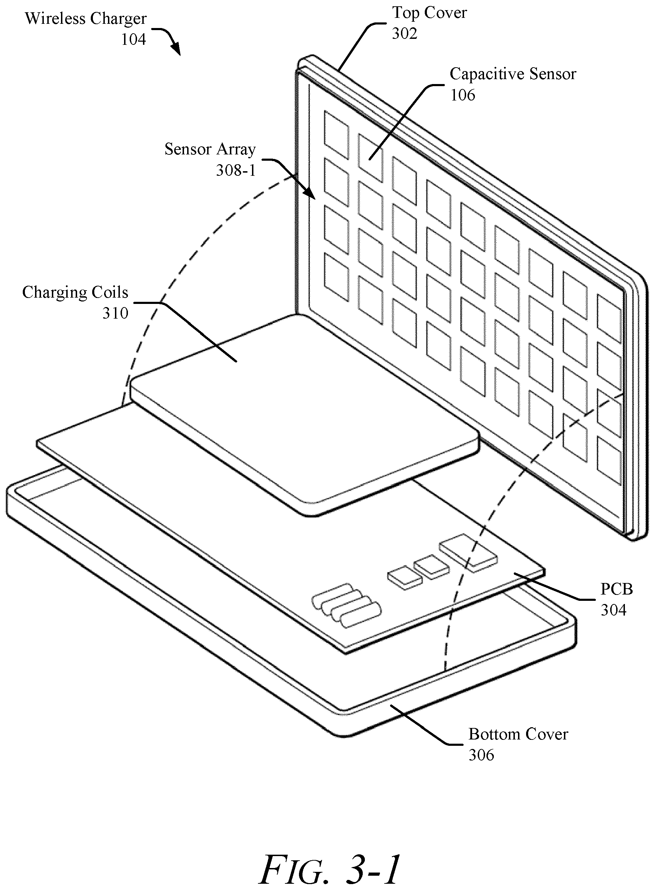

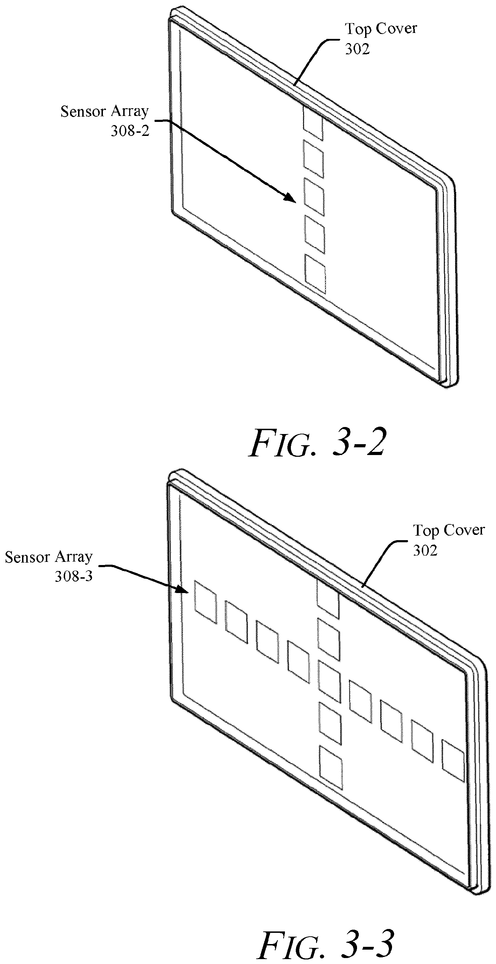

FIGs. 3-1 through 3-3 illustrate an example wireless charger that performs capacitive sensing to detect battery deformations. The wireless charger of FIGs. 3-1 through 3-3 can, for example, be the wireless charger 104 of FIGs. 1 and 2. FIG. 3-1 provides a simplified diagram of the structure of the wireless charger 104, which may include additional layers and components not illustrated or discussed in FIG. 3-1.

The wireless charger 104 may include a top cover 302, a printed circuit board (PCB) 304, and a bottom cover 306. The top cover 302 provides a surface on which a mobile device (e.g., the smartphone 110) may be placed to initiate a charging session. Multiple capacitive sensors 106 may be affixed to or on a bottom or underside surface of the top cover 302. The wireless charging monitor 108 utilizes the capacitive sensors 106 to detect changes in the surface geometry of the rechargeable battery 112 or the mobile device containing it by measuring changes in capacitance at or among the capacitive sensors 106. As described in greater detail below, in the case of a deformed battery, the surface of the rechargeable battery 112 or the smartphone 110 becomes rounded, resulting in much lower capacitance measured at the edge or central capacitive sensors 106 depending on the direction of the deformation.

As illustrated in FIGs. 3-1 through 3-3, the capacitive sensors 106 may be arranged in different sensor arrays 308. In FIG. 3-1, the sensor array 308-1 includes a two-dimensional array of capacitive sensors 106 with four capacitive sensors 106 in a longitudinal or horizontal direction and nine capacitive sensors 106 in a lateral or vertical direction. In other implementations, the sensor array 308-1 may include more or fewer capacitive sensors 106 along the longitudinal or lateral directions. The sensory array 308-1 may also include a sparsely populated array (e.g., in a waffle design) with one or more capacitive sensors 106 missing along the longitudinal or lateral directions.

In FIG. 3-2, the sensor array 308-2 includes five capacitive sensors 106 arranged in the longitudinal direction. The sensor array 308-2 is ideally located near a midpoint along the lateral direction so that capacitance values may be obtained along the longitudinal or horizontal axis of a mobile device at or near its lateral center. In other implementations, the sensor array 308-2 may include more or fewer capacitive sensors 106. The sensor array 308-2 may also be arranged in the lateral direction as opposed to the longitudinal direction.

In FIG. 3-3, the sensor array 308-3 includes a longitudinal array (with five sensors) and a lateral array (with nine sensors) of capacitive sensors 106 forming a T-shape or cross. The longitudinal and lateral arrays of the sensor array 308-3 are ideally located near a midpoint along the lateral direction and the longitudinal direction, respectively. In other implementations, the sensor array 308-3 may include more or fewer capacitive sensors 106 in the longitudinal array or the lateral array.

The PCB 304 may include control circuitry for the wireless charger 104. In addition, charging coils 310 may be located on or affixed to the PCB 304. The charging coils 310 create an oscillating magnetic field, which can create a charging current in the rechargeable battery 112.

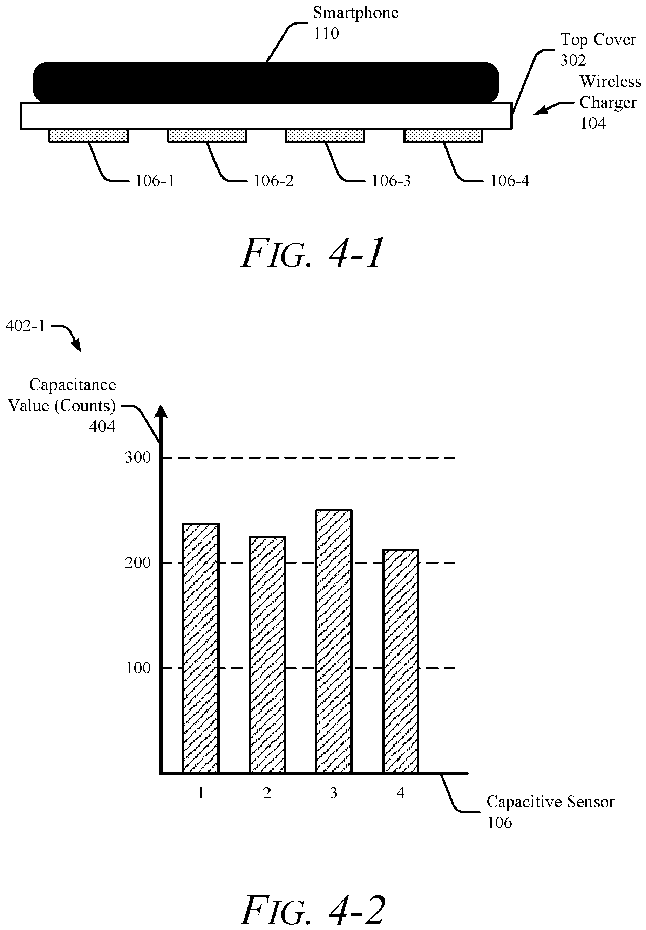

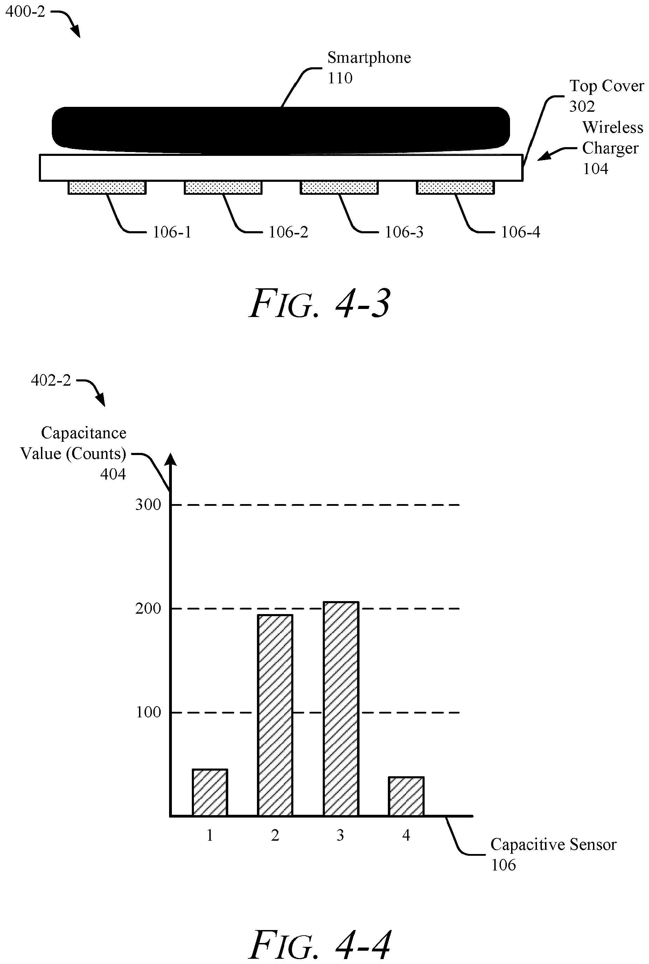

FIGs. 4-1 through 4-4 illustrate an example charging session in which capacitive sensing is used to detect a battery deformation in accordance with techniques of this disclosure. In FIG. 4-1, a smartphone (e.g., the smartphone 110 of FIG. 1) is placed on a wireless charger (e.g., the wireless charger 104 of FIG. 1). In this example illustration, the wireless charger 104 includes four capacitive sensors 106, including a first capacitive sensor 106-1, a second capacitive sensor 106-2, a third capacitive sensor 106-3, and a fourth capacitive sensor 106-4. The capacitive sensors 106 are affixed to the bottom surface of the top cover 302.

Many mobile devices with rechargeable batteries (e.g., the smartphone 110) have planar (flat) surfaces by design. Similarly, the embedded battery packs are often designed so that at least one surface is planar in at least one dimension. As a result, and as illustrated in FIG. 4-1, the smartphone 110 with a non-deformed rechargeable battery 112 sits flat on the top cover 302.

In FIG. 4-2, a graph 402-1 illustrates capacitance values 404 for each capacitive sensor 106 associated with the charging session of FIG. 4-1. When a mobile device with a non-deformed battery, including the smartphone 110 of FIG. 4-1, is placed on the wireless charger 104, the capacitance values 404 are fairly consistent or uniform across the array of capacitive sensors 106 because the distance between the smartphone 110 and the capacitive sensors 106 is uniform. The output of the capacitive sensors 106 is presented in counts, which are analogous or proportional to capacitance, but are not equal to capacitance. For example, in graph 402-1, the capacitance values 404 for the capacitive sensors 106 are approximately 240, 225, 255, and 210 counts, respectively.

The capacitive sensors 106 measure the capacitance of a dielectric stack, which includes the top cover 302 and the smartphone 110. The stacked dielectrics can be modeled as a series of capacitors, where the total capacitance, C, measured by each capacitive sensor 106 is represented by Equation (1):

$$\frac{1}{C} = \frac{1}{C_1} + \frac{1}{C_2} \qquad (1)$$

where $C_1$ and $C_2$ represent the capacitance of the top dielectric (e.g., the smartphone 110) and the bottom dielectric (e.g., the top cover 302), respectively, and are determined using Equation (2):

$$C_{1,2} = k_{1,2} C_0 \frac{(d_1 + d_2)}{d_{1,2}} \qquad (2)$$

where $C_0$ is determined using Equation (3):

$$C_0 = \frac{\varepsilon_0 A}{(d_1 + d_2)} \qquad (3)$$

where $k_1$ and $k_2$ represent the permittivity of the top dielectric and the bottom dielectric, respectively, $A$ represents the plate area, $d_1$ and $d_2$ represent the thickness of the top dielectric and the bottom dielectric, respectively, and $\varepsilon_0$ represents the permittivity of space (approximately 8.854 pF/m). If there were two independent parallel plate capacitors in series, then the resultant capacitance could be determined by a product-over-sum calculation and the total capacitance would always be less than the smaller of the two capacitors. However, the combination of the wireless charger 104 and the smartphone 110 can be considered a single capacitor constructed by stacking dielectrics within a shared set of plates. As a result, the capacitance contributed by each dielectric (e.g., the top cover 302 and the smartphone 110) is proportional to the thickness of each dielectric to the total thickness of the dielectric stack. The capacitance of the dielectric stack illustrated in FIG. 4-1 can be determined by rewriting Equations (1) through (3) as Equations (4) and (5):

$$C = k_s C_0 \qquad (4)$$

where $k_s$ is the dielectric constant of the stack, which is determined using Equation (5):

$$C = \frac{k_1 k_2 (d_1 + d_2)}{k_2 d_1 + k_1 d_2}. \qquad (5)$$

In FIG. 4-3, as the smartphone 110 charges on the wireless charger 104 (or over a series of charging sessions) outgassing within the rechargeable battery 112 has occurred, causing it to swell. The swelling has also deformed the smartphone 110 such that the bottom surface is no longer flat or planar. Instead, a bulge has formed along a central lateral or vertical axis of the smartphone 110, causing an air gap between the smartphone 110 and the top cover 302 over the first capacitive sensor 106-1 and the fourth capacitive sensor 106-4. The deformation of the smartphone 110 indicates that the rechargeable battery 112 has been compromised or is failing and should be replaced.

As illustrated in graph 402-2 of FIG. 4-4, as the rechargeable battery 112 has deformed, the capacitance between the smartphone 110 and some capacitive sensors 106, specifically the first capacitive sensor 106-1 and the fourth capacitive sensor 106-4 in this example, changes because of the air gap forming between the top cover 302 and the smartphone 110. For example, in graph 402-2, the capacitance values 404 for the capacitive sensors 106 are approximately 50, 190, 205, and 40 counts, respectively. As the smartphone's surface has rounded, a much lower capacitance is measured at the edge capacitive sensors (e.g., the first capacitive sensor 106-1 and the fourth capacitive sensor 106-4) than at the middle capacitive sensors (e.g., the second capacitive sensor 106-2 and the third capacitive sensor 106-3). Because air has a much lower dielectric constant (e.g., approximately 1) than the plastic (e.g., approximately 2.7) in the smartphone 110 and the top cover 302, the capacitance resulting from the dielectric stack of plastic-air-plastic is measurably lower than the capacitance from the stack of plastic on plastic without an air gap. A similar observation may be utilized with cylindrical cells, packs of cylindrical cells, and prismatic cells to detect battery swelling from outgassing.

EXAMPLE METHODS

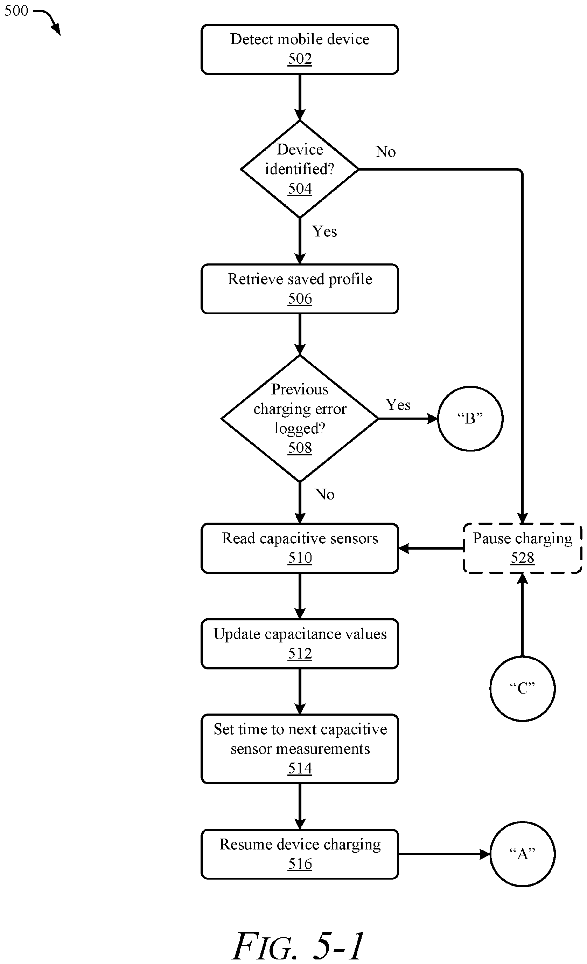

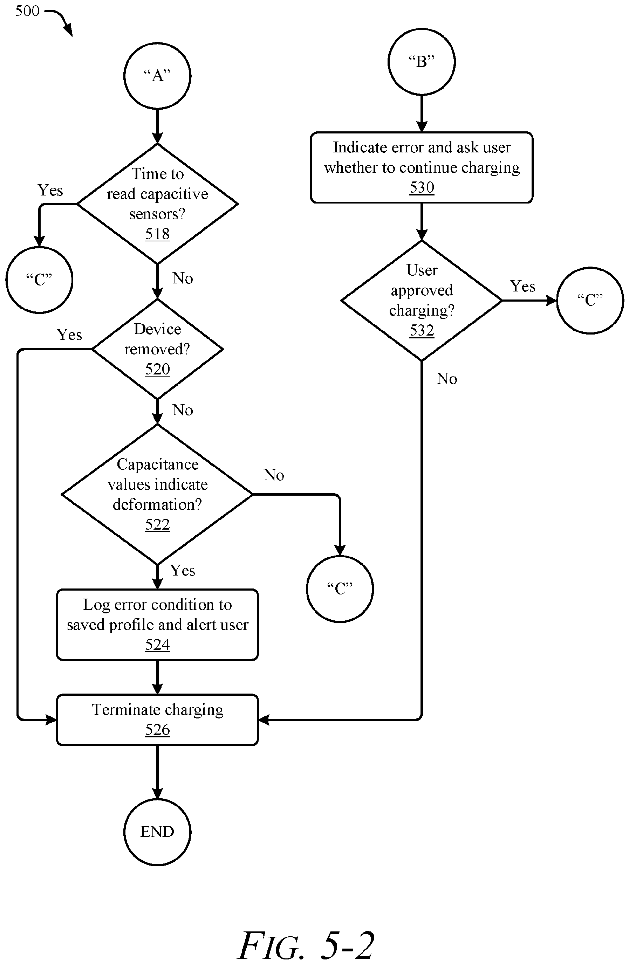

FIGs. 5-1 and 5-2 illustrate an example flow chart 500 for capacitive sensing to detect battery deformations during wireless charging. Flow chart 500 is shown as operations (or acts) performed, but not necessarily limited to the order or combinations in which the operations are shown herein. Further, any one of one or more of the operations may be repeated, combined, or reorganized to provide other flow charts. In portions of the following discussion, reference may be made to entities detailed in FIGs. 1 through 4-4 reference to which is made for example only. The techniques are not limited to performance by one entity or multiple entities. Although flow chart 500 provides example operations for a mobile device, the same or similar operations may be implemented to detect deformation in various systems, including embedded and backup batteries in vehicles.

At operation 502, the placement of a mobile device (e.g., smartphone 110 on a wireless charger is detected. For example, drivers may place their smartphone 110 on the wireless charger 104 while commuting to work. The wireless charging monitor 108 detects the presence of the smartphone 110 on the wireless charger 104.

At operation 504, it is determined whether the mobile device has previously been identified. For example, the wireless charging monitor 108 determines whether it was previously identified as the smartphone 110. The smartphone 110 may send data packets identifying itself and provide configuration and setup information to the wireless charger 104. The wireless charging monitor 108 can then check the saved profiles 210 for one associated with the smartphone 110.

At operation 506, if the mobile device has been previously identified, a saved profile for the mobile device is retrieved. For example, the wireless charging monitor 108 retrieves the saved profile 210 associated with the smartphone 110 if the smartphone 110 has previously been identified by the wireless charging monitor 108.

At operation 508, it is determined whether a previous charging error has been logged. For example, the wireless charging monitor 108 determines whether the saved profile 210 or another log associated with the smartphone 110 indicates a previous charging error was logged for the smartphone 110.

At operation 510, if a previous charging error has not been logged, the capacitive sensors are read. In addition, if the mobile device has not been previously identified in operation 504, flow chart 500 proceeds to operation 510. For example, if a charging error has not been logged for the smartphone 110, the wireless charging monitor 108 obtains or reads capacitance values 404 from the capacitive sensors 106.

At operation 512, capacitance values for the mobile device are updated. For example, the capacitance comparator 208 updates long-term (e.g., over a number of measurement cycles) and short-term (e.g., for the most recent measurement cycle) averages for the capacitance values. The capacitance comparator 208 may also determine long-term and short-term standard deviations, variances, ranges, and/or minima for the capacitance values.

At operation 514, the time to capture or read the next capacitive sensor measurements is set or otherwise determined. For example, the wireless charging monitor 108 sets or reads from a predefined value the time to read or obtain the next set of capacitance measurements or values from the capacitive sensors 106. The wireless charging monitor 108 may be preprogrammed to obtain or read the capacitive sensors 106 at a certain frequency (e.g., every 10 seconds).

At operation 516, device charging is initiated or resumed. For example, the wireless charger 104 initiates, resumes, or continues charging the smartphone 110. The wireless charging monitor 108 may not initiate the charging session until the capacitance comparator 208 determines that battery deformation is not indicated by the capacitance values 404.

At operation 518, it is determined whether it is time to read the capacitive sensors. For example, the wireless charging monitor 108 determines whether it is time for the next measurement cycle for the capacitive sensors 106. If it is time to read the capacitive sensors 106 (e.g., for the next measurement cycle), then flow chart 500 performs optional operation 528, which is described in greater detail below, and/or returns to operation 510 (as indicated by the "C" in FIGs. 5-1 and 5-2).

At operation 520, if it is not time to read the capacitive sensors (again), it is determined whether the mobile device has been removed from the wireless charger. For example, the wireless charging monitor 108 determines whether the smartphone 110 has been removed from the wireless charger 104.

If the mobile device has been removed from the wireless charger, then flow chart 500 proceeds to operation 526 and terminates charging. For example, if the wireless charging monitor 108 determines that the smartphone 110 has been removed from the wireless charger 104, the charging session or charging by the wireless charger 104 is terminated.

At operation 522, if the mobile device has not been removed, it is determined whether the capacitance values indicate deformation of the rechargeable battery or the mobile device. For example, if the smartphone 110 has not been removed from the wireless charger 104, the capacitance comparator 208 determines whether the capacitance values 404 indicate deformation or swelling of the rechargeable battery 112. The capacitance comparator 208 may identify potential deformation of the rechargeable battery 112 if the difference between the short-term average of capacitance values 404 and the long-term (e.g., all previous measurement cycles or a set number of previous measurement cycles) average of capacitance values 404 is greater than a threshold value. Because swelling may introduce an air gap in the surface of the smartphone 110 adjacent to the top cover 302, the short-term average will be significantly lower than the long-term average before the deformation.

Similarly, the capacitance comparator 208 may identify a deformation from the short-term standard deviation, variance, or range being greater than a respective threshold value. A deformation may also be indicated by the difference between the short-term and long-term standard deviation, variance, or range being greater than another threshold value. The short-term minimum or a comparison to the long-term minimum may indicate that the rechargeable battery 112 has swelled.

At operation 524, if the capacitance values indicate deformation, an error condition is logged in the saved profile, and the user is alerted. For example, the wireless charging monitor 108 logs the error condition in the saved profile 210 associated with the smartphone 110 in response to the capacitance values 404 indicating deformation of the rechargeable battery 112 or the smartphone 110. The wireless charging monitor 108 also provides an alert of the error condition to the user (e.g., the driver). The alert can be provided on a display in the host vehicle 102 (e.g., an infotainment display in the central console), on a display integrated into or on the wireless charger 104 (e.g., a small screen or LED that can indicate an error condition), or on the smartphone 110.

At operation 526, charging is terminated. For example, the wireless charging monitor 108 causes the wireless charger 104 to terminate the charging session or cease charging the smartphone 110.

At optional operation 528, if the capacitance values do not indicate deformation, charging may be paused and flow chart 500 proceeds to operation 518 (as indicated by "C" in FIGs. 5-1 and 5-2). For example, the wireless charging monitor 108 may optionally pause the charging session in response to the capacitance values 404 not indicating deformation of the smartphone 110, and then proceed to read capacitance values 404 from the capacitive sensors 106. Wireless charging may be paused so that any radiated emissions from the wireless charger 104 do not impact the capacitance measurements in operation 512. In some wireless chargers or implementations, no such impact may occur and pausing the wireless charging may not be required. In other implementations, the wireless charging monitor 108 may skip operation 528 and proceed directly to operation 510.

At operation 530, in response to a previous charging error being logged for the mobile device in the saved profile (as indicated by "B" in FIGs. 5-1 and 5-2), the previous charging error is indicated to the user and the user is asked whether to continue the charging session. For example, the wireless charging monitor 108 may indicate a previous charging error on a display (e.g., in the host vehicle 102, on the wireless charger 104, or on the smartphone 110) and prompt the user to indicate whether charging should continue or be initiated.

At operation 532, it is determined whether the user approved continuing or initiating the charging. For example, the wireless charging monitor 108 determines whether the user indicated whether the charging session for the smartphone 110 should continue or be initiated. The driver may determine to initiate the charging session because a visual inspection of the smartphone 110 indicates that it is not deformed. The driver may also know that the rechargeable battery 112 was replaced or repaired after the previous error occurred.

If the user approves continuing or commencing the charging, flow chart 500 performs optional operation 528 and/or proceeds to operation 510 to read the capacitive sensors (as indicated by "C" in FIGs. 5-1 and 5-2). In such situations, the wireless charging monitor 108 may clear or delete the previous charging error from the saved profile 210 associated with the smartphone 110. If the user does not approve continuing or commencing the charging, flow chart 500 proceeds to operation 526 and terminates charging.

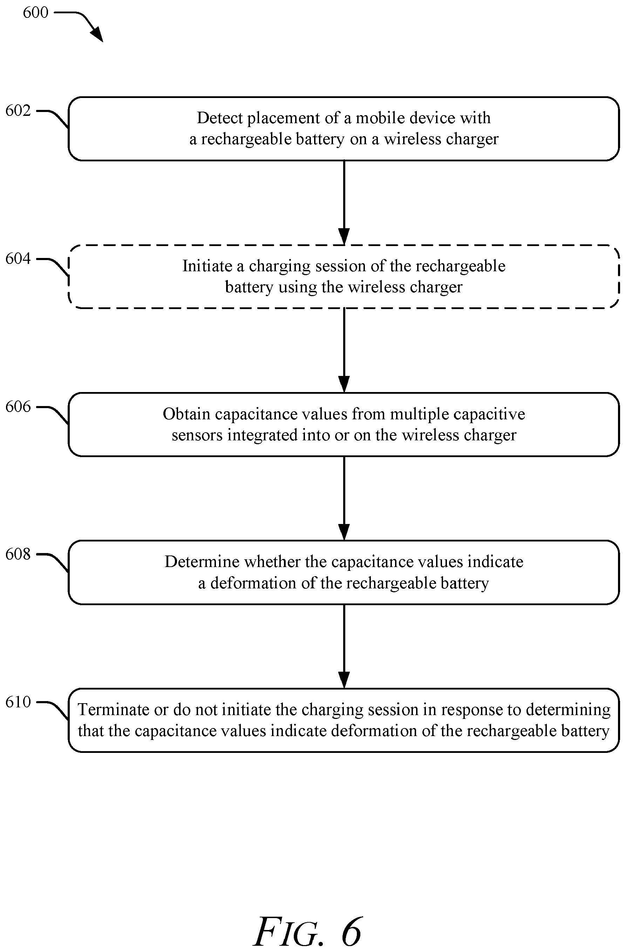

FIG. 6 illustrates an example method 600 for capacitive sensing to detect battery deformations during wireless charging. Method 600 is shown as operations (or acts) performed, but not necessarily limited to the order or combinations in which the operations are shown herein. Further, any one of one or more of the operations may be repeated, combined, or reorganized to provide other methods. In portions of the following discussion, reference may be made to entities or operations detailed in FIGs. 1 through 5-2 reference to which is made for example only. The techniques are not limited to performance by one entity or multiple entities of one operation or multiple operations.

At step 602, the placement of a mobile device with a rechargeable battery on a wireless charger is detected. For example, the wireless charging monitor 108 may detect that a mobile device, including the smartphone 110, with the rechargeable battery 112 is on the wireless charger 104. The mobile device may also include a tablet, a computer, a smartwatch, or some other type of consumer product with a rechargeable battery. The wireless charger 104 may be a standalone induction charging pad or an induction charging pad integrated into another device (e.g., a charging pad integrated into a portion of the host vehicle 102).

At optional step 604, a charging session of the rechargeable battery is initiated using the wireless charger. For example, the wireless charging monitor 108 may cause the wireless charger 104 to initiate or begin a charging session of the rechargeable battery 112. In other implementations, the charging session may initiate after confirming that the capacitance values 404 do not indicate battery deformation.

Before initiating the charging session, the wireless charging monitor 108 may obtain or determine an identification of the particular mobile device (e.g., the smartphone 110) and retrieve the saved profile 210 associated with that mobile device. Similarly, a default profile associated with that type of mobile device (e.g., if this is the first charging session for the smartphone 110 by the wireless charger 104) or for popular models of that type of mobile device. The wireless charging monitor 108 may also determine from the saved profile 210 or based on the identification of the mobile device, whether a previous charging error was logged for that mobile device. If a previous charging error exists for the particular mobile device, the wireless charging monitor 108 may cause it to be indicated on a user interface and prompt the user to indicate whether to initiate (or continue) the charging session. Depending on the installation of the wireless charger 104, the user interface may be provided on the display 202 in the host vehicle 102, a display associated with or integrated into the wireless charger 104, or a display of the mobile device. For example, communication devices 212 may include Bluetooth® or other short-range communication capabilities to create a user interface for advanced charging features and displaying alerts.

In response to obtaining user input indicating to initiate or continue the charging session, the wireless charging monitor 108 causes the wireless charger 104 to initiate or continue the charging session. In response to obtaining user input indicating to not initiate or continue the charging session, the wireless charging monitor 108 causes the wireless charger 104 to terminate or not initiate the charging session.

At step 606, capacitance values are obtained from multiple capacitive sensors integrated into or on the wireless charger. For example, the wireless charging monitor 108 obtains or reads capacitance values 404 from the capacitive sensors 106. As described above, the capacitive sensors 106 may be arranged between an inductive charging circuit and a top cover 302 (e.g., a top layer) on which the smartphone 110 is placed for charging. For example, the capacitive sensors are affixed to the underside of the top cover 302. The capacitive sensors 106 may be arranged in a horizontal (or longitudinal) array, a vertical (or lateral) array, or a combination of the horizontal array and the vertical array. In this way, the capacitive sensors 106 are laid out to obtain the capacitance values 404 from different positions along a horizontal (or longitudinal) axis or a vertical (or lateral) axis of the smartphone 110.

In some implementations, the wireless charging monitor 108 may ignore or delete the capacitance values 404 for a measurement cycle of the charging session in response to detecting or receiving notification of a vibration event (e.g., the host vehicle 102 traveling over train tracks). The vibration event may be detected using an inertial measurement unit of the wireless charger 104, the host vehicle 102, or the smartphone 110.

At step 608, it is determined whether the capacitance values indicate deformation of the rechargeable battery. For example, the capacitance comparator 208 may analyze the capacitance values 404 and determine whether they indicate battery deformation, which is caused by swelling or enlargement of the rechargeable battery 112 resulting in a variable distance or an air gap between a top surface of the wireless charger 104 and a bottom surface of the smartphone 110. The battery deformation, which is relative to the placement on the wireless charger, may cause variation in the air gap distance between the bottom surface of the smartphone 110 and the top surface of the wireless charger 104. In other words, the deformation may result in the portions of the bottom surface of the smartphone 110 being further separated from the top surface of the wireless charger 104 than other parts of the smartphone 110.

The capacitance comparator 208 may use a variety of analyses and statistical methods to identify the battery deformation. For example, battery deformation may be determined based on at least one of the following: the current (or short-term) average of the capacitance values 404 being less than the previous average (or long-term or rolling averages) of capacitance values 404 or being less than a threshold average value, which may be set for the particular device based on initial averages or based on the type of device; the standard deviation of the capacitance values 404 being greater than the previous standard deviation of capacitance values 404 or a threshold standard deviation value; or at least one of the capacitance values 404 (e.g., a minimum capacitance value) being below a threshold value. The threshold values may be determined based on the saved profile 210 or a default profile associated with the smartphone 110.

In other implementations, the capacitance comparator 208 may use a machine-learned model to identify the battery deformation based on the capacitance values 404. The machine-learned model may be trained to receive the capacitance values 404 and classify the rechargeable battery 112 as deformed or not deformed. The machine-learned model may perform classification, tracing, and/or other tasks related to identifying potential battery deformations during wireless charging.

For classifications, the machine-learned model can be trained using supervised learning techniques. For example, the wireless charging monitor 108 or an offline system can train the machine-learned model with training data (e.g., ground truth data) that includes capacitance values 404 labeled as deformed or not deformed. The labels can be manually applied by engineers or provided by other techniques (e.g., based on data from other charging systems). The training dataset can include capacitance values 404 like those input to the machine-learned model during the operation of the wireless charger 104.

The machine-learned model can be trained offline, e.g., in a training computing system, and then provided for storage and implementation on one or more wireless chargers. For example, the training computing system can include a model trainer. The training computing system can be included in or separate from the processor implementing the machine-learned model.

In some implementations, the machine-learned model may implement logistic regression, a decision tree, or a multi-layer perceptron. These machine-learned models may be chosen if the processor of the wireless charger 104 has limited processing capabilities. If the processor has greater processing capabilities, additional types of models may be employed. Logistic regression uses a Sigmoid function to map the final output into an interval between zero and one, representing the probability of the input being in each category (e.g., deformed or not deformed). Extracted features from the capacitance values 404 may be used to improve the performance of logistic regression. Decision trees use a white-box model to show which extracted features are important in the classification. A multi-layer perceptron is a feed-forward neural network that uses linear combinations of the features and a non-linear activation function to generate the classification output. Weights of the activation function are updated or learned iteratively using a gradient-based optimization method (e.g., via backpropagation) during the training phase.

The wireless charging monitor 108 may also obtain or read the capacitance values 404 periodically. Thus, in response to a cycle time expiring, the wireless charging monitor 108 obtains or reads new capacitance values 404 from the capacitive sensors 106 during the charging session. The capacitance comparator 208 determines whether the new capacitance values 404 indicate battery deformation.

At step 610, the charging session is terminated or not initiated in response to determining that the capacitance values indicate the deformation of the rechargeable battery. For example, the wireless charging monitor 108 terminates or does not initiate the charging session in response to determining whether the analysis of the capacitance values 404 or new capacitance values 404 (e.g., from a later measurement cycle) indicate battery deformation. The wireless charging monitor 108 may also log the charging error or battery deformation in the saved profile 210 associated with the smartphone 110 and alert the user via a display or user interface of the potential battery deformation.

ADDITIONAL EXAMPLES

In the following section, additional examples are provided.

Example 1. A wireless charger comprising: multiple capacitive sensors integrated into or on the wireless charger; and one or more processors configured to: detect placement of a mobile device with a rechargeable battery on the wireless charger; obtain capacitance values from the multiple capacitive sensors; determine whether the capacitance values indicate deformation of the rechargeable battery; and in response to a determination that the capacitance values indicate deformation of the rechargeable battery, terminate or cease to initiate a charging session by the wireless charger of the rechargeable battery.

Example 2. The wireless charger of Example 1, wherein the multiple capacitive sensors are arranged between an inductive charging circuit and a top cover or a top layer of the wireless charger in at least one of a horizontal array, a vertical array, or a combination of the horizontal array and the vertical array to obtain the capacitance values from different positions along a horizontal axis or a vertical axis of the mobile device.

Example 3. The wireless charger of Example 2, wherein the multiple capacitive sensors are affixed to an underside of the top cover or the top layer on which the mobile device is placed.

Example 4. The wireless charger of any one of the previous Examples, wherein the one or more processors are configured to determine that the capacitance values indicate deformation of the rechargeable battery using at least one of: determining an average of the capacitance values is less than a previous average of capacitance values or a threshold average value; determining a standard deviation of the capacitance values is greater than a previous standard deviation of capacitance values or a threshold standard deviation value; or determining at least one of the capacitance values is below a threshold value.

Example 5. The wireless charger of any one of the previous Examples, wherein the one or more processors are configured to determine whether the capacitance values indicate deformation of the rechargeable battery using a machine-learned model to identify the deformation based on the capacitance values.

Example 6. The wireless charger of any one of the previous Examples, wherein the one or more processors are further configured to: in response to a cycle time expiring, obtain new capacitance values from the multiple capacitive sensors during the charging session; and determine whether the new capacitance values indicate the deformation of the rechargeable battery.

Example 7. The wireless charger of any one of the previous Examples, wherein the one or more processors are further configured to: determine an identification of the mobile device; and retrieve a saved profile or a default profile associated with the identification of the mobile device, wherein the one or more processors are configured to determine whether the capacitance values indicate deformation of the rechargeable battery by comparing the capacitance values to the saved profile or the default profile.

Example 8. The wireless charger of Example 7, wherein the one or more processors are further configured to: determine, from the saved profile or based on the identification of the mobile device, whether a previous charging error was logged for the mobile device; cause the previous charging error to be indicated on a user interface and ask a user whether to continue or initiate the charging session; and in response to obtaining user input indicating to continue or initiate charging, continue or initiate the charging session of the rechargeable battery; or in response to obtaining user input indicating not to continue or initiate charging, terminate or do not initiate the charging session of the rechargeable battery.

Example 9. The wireless charger of Example 8, wherein the user interface comprises at least one of a display in a host vehicle in which the wireless charger is installed, a display associated with the wireless charger, or a display of the mobile device.

Example 10. The wireless charger of any one of Examples 7 through 9, wherein the one or more processors are further configured to: in response to the capacitance values indicating deformation of the rechargeable battery, log a charging error associated with the identification of the mobile device; and in response to the capacitance values indicating deformation of the rechargeable battery, alert a user via a display of the charging error.

Example 11. The wireless charger of any one of the previous Examples, wherein the one or more processors are further configured to: in response to detecting a vibration event, ignore the capacitance values for a cycle of the charging session, the vibration event being detected using an inertial measurement unit of the wireless charger or a host vehicle in which the wireless charger is installed.

Example 12. A method comprising: detecting placement of a mobile device with a rechargeable battery on a wireless charger; obtaining capacitance values from multiple capacitive sensors integrated into or on the wireless charger;

determining whether the capacitance values indicate deformation of the rechargeable battery; and in response to determining that the capacitance values indicate deformation of the rechargeable battery, terminating or not initiating a charging session of the rechargeable battery.

Example 13. The method of Example 12, wherein the mobile device includes at least one of a smartphone, a tablet, a computer, or a smartwatch.

Example 14. The method of Example 12 or 13, wherein the deformation is caused by swelling or enlargement of the rechargeable battery that results in a variable distance or an air gap between a top surface of the wireless charger and a bottom surface of the mobile device.

Example 15. A non-transitory computer-readable medium that stores computer-executable instructions that, when executed by a processor, cause the processor to perform the method of any one of Examples 12 through 14.

CONCLUSION

While various embodiments of the disclosure are described in the foregoing description and shown in the drawings, it is to be understood that this disclosure is not limited thereto but may be variously embodied to practice within the scope of the following claims. From the foregoing description, it will be apparent that various changes may be made without departing from the scope of the disclosure as defined by the following claims.

**Claims**

1. A wireless charger comprising:

   multiple capacitive sensors integrated into or on the wireless charger; and
   one or more processors configured to:

      detect placement of a mobile device with a rechargeable battery on the wireless charger;
      obtain capacitance values from the multiple capacitive sensors;
      determine whether the capacitance values indicate deformation of the rechargeable battery; and
      in response to a determination that the capacitance values indicate deformation of the rechargeable battery, terminate or cease to initiate a charging session by the wireless charger of the rechargeable battery.

2. The wireless charger of claim 1, wherein the multiple capacitive sensors are arranged between an inductive charging circuit and a top cover or a top layer of the wireless charger in at least one of a horizontal array, a vertical array, or a combination of the horizontal array and the vertical array to obtain the capacitance values from different positions along a horizontal axis or a vertical axis of the mobile device.

3. The wireless charger of claim 2, wherein the multiple capacitive sensors are affixed to an underside of the top cover or the top layer on which the mobile device is placed.

4. The wireless charger of any one of the previous claims, wherein the one or more processors are configured to determine that the capacitance values indicate deformation of the rechargeable battery using at least one of:

      determining an average of the capacitance values is less than a previous average of capacitance values or a threshold average value;
      determining a standard deviation of the capacitance values is greater than a previous standard deviation of capacitance values or a threshold standard deviation value; or
      determining at least one of the capacitance values is below a threshold value.

5. The wireless charger of any one of the previous claims, wherein the one or more processors are configured to determine whether the capacitance values indicate deformation of the rechargeable battery using a machine-learned model to identify the deformation based on the capacitance values.

6. The wireless charger of any one of the previous claims, wherein the one or more processors are further configured to:

      in response to a cycle time expiring, obtain new capacitance values from the multiple capacitive sensors during the charging session; and
      determine whether the new capacitance values indicate the deformation of the rechargeable battery.

7. The wireless charger of any one of the previous claims, wherein the one or more processors are further configured to:

   determine an identification of the mobile device; and
   retrieve a saved profile or a default profile associated with the identification of the mobile device,
   wherein the one or more processors are configured to determine whether the capacitance values indicate deformation of the rechargeable battery by comparing the capacitance values to the saved profile or the default profile.

8. The wireless charger of claim 7, wherein the one or more processors are further configured to:

   determine, from the saved profile or based on the identification of the mobile device, whether a previous charging error was logged for the mobile device;
   cause the previous charging error to be indicated on a user interface and ask a user whether to continue or initiate the charging session; and
   in response to obtaining user input indicating to continue or initiate charging, continue or initiate the charging session of the rechargeable battery; or
   in response to obtaining user input indicating not to continue or initiate charging, terminate or do not initiate the charging session of the rechargeable battery.

9. The wireless charger of claim 8, wherein the user interface comprises at least one of a display in a host vehicle in which the wireless charger is installed, a display associated with the wireless charger, or a display of the mobile device.

10. The wireless charger of any one of claims 7 through 9, wherein the one or more processors are further configured to:

    in response to the capacitance values indicating deformation of the rechargeable battery, log a charging error associated with the identification of the mobile device; and
    in response to the capacitance values indicating deformation of the rechargeable battery, alert a user via a display of the charging error.

11. The wireless charger of any one of the previous claims, wherein the one or more processors are further configured to: in response to detecting a vibration event, ignore the capacitance values for a cycle of the charging session, the vibration event being detected using an inertial measurement unit of the wireless charger or a host vehicle in which the wireless charger is installed.

12. A method comprising:

    detecting placement of a mobile device with a rechargeable battery on a wireless charger;
    obtaining capacitance values from multiple capacitive sensors integrated into or on the wireless charger;
    determining whether the capacitance values indicate deformation of the rechargeable battery; and
    in response to determining that the capacitance values indicate deformation of the rechargeable battery, terminating or not initiating a charging session of the rechargeable battery.

13. The method of claim 12, wherein determining whether the capacitance values indicate deformation of the rechargeable battery comprises at least one of:

    determining an average of the capacitance values is less than a previous average of capacitance values or a threshold average value;
    determining a standard deviation of the capacitance values is greater than a previous standard deviation of capacitance values or a threshold standard deviation value; or
    determining at least one of the capacitance values is below a threshold value.

14. The method of claim 12 or 13, wherein determining whether the capacitance values indicate deformation of the rechargeable battery comprises using a machine-learned model to identify the deformation based on the capacitance values.

15. A non-transitory computer-readable medium that stores computer-executable instructions that, when executed by a processor, cause the processor to perform the method of any one of claims 12 through 14.

Host Vehicle
102

104

112

110

Wireless Charger
104

Capacitive Sensors
106

Wireless Charging Monitor
108

*FIG. 1*

200 ⌐

```
┌─────────────────────────────────────────┐
│              Host Vehicle                │
│                  102                     │
│  ┌───────────────────────────────────┐  │
│  │         Wireless Charger          │  │
│  │               104                 │  │
│  │  ┌─────────────────────────────┐  │  │
│  │  │      Capacitive Sensors     │  │  │
│  │  │            106              │  │  │
│  │  └─────────────────────────────┘  │  │
│  └───────────────────────────────────┘  │
│  ┌───────────────────────────────────┐  │
│  │             Display               │  │
│  │               202                 │  │
│  └───────────────────────────────────┘  │
│  ┌───────────────────────────────────┐  │
│  │           Processor(s)            │  │
│  │               204                 │  │
│  └───────────────────────────────────┘  │
│  ┌───────────────────────────────────┐  │
│  │  Computer-Readable Storage Media  │  │
│  │               206                 │  │
│  │  ┌─────────────────────────────┐  │  │
│  │  │  Wireless Charging Monitor  │  │  │
│  │  │            108              │  │  │
│  │  │ ┌─────────────────────────┐ │  │  │
│  │  │ │  Capacitance Comparator │ │  │  │
│  │  │ │          208            │ │  │  │
│  │  │ └─────────────────────────┘ │  │  │
│  │  │ ┌─────────────────────────┐ │  │  │
│  │  │ │     Saved Profile(s)    │ │  │  │
│  │  │ │          210            │ │  │  │
│  │  │ └─────────────────────────┘ │  │  │
│  │  └─────────────────────────────┘  │  │
│  └───────────────────────────────────┘  │
│  ┌───────────────────────────────────┐  │
│  │      Communication Device(s)      │  │
│  │               212                 │  │
│  └───────────────────────────────────┘  │
└─────────────────────────────────────────┘
```

*FIG. 2*

Wireless Charger
104

Top Cover
302

Capacitive Sensor
106

Sensor Array
308-1

Charging Coils
310

PCB
304

Bottom Cover
306

*FIG. 3-1*

Top Cover
302

Sensor Array
308-2

*FIG. 3-2*

Top Cover
302

Sensor Array
308-3

*FIG. 3-3*

Smartphone 110

Top Cover 302

Wireless Charger 104

106-1  106-2  106-3  106-4

*FIG. 4-1*

402-1

Capacitance Value (Counts) 404

300

200

100

1  2  3  4

Capacitive Sensor 106

*FIG. 4-2*

400-2

Smartphone
110

Top Cover
302
Wireless
Charger
104

106-1    106-2    106-3    106-4

## FIG. 4-3

402-2

Capacitance
Value (Counts)
404

300

200

100

1    2    3    4

Capacitive Sensor
106

## FIG. 4-4

500

FIG. 5-1

500

"A"

"B"

Indicate error and ask user
whether to continue charging
530

Time to
read capacitive
sensors?
518

Yes → "C"

No

User
approved
charging?
532

Yes → "C"

No

Device
removed?
520

Yes

No

Capacitance
values indicate
deformation?
522

No → "C"

Yes

Log error condition to
saved profile and alert user
524

Terminate charging
526

END

*FIG. 5-2*

600 —

602 — Detect placement of a mobile device with
a rechargeable battery on a wireless charger

604 — Initiate a charging session of the rechargeable
battery using the wireless charger

606 — Obtain capacitance values from multiple capacitive
sensors integrated into or on the wireless charger

608 — Determine whether the capacitance values indicate
a deformation of the rechargeable battery

610 — Terminate or do not initiate the charging session in response to determining
that the capacitance values indicate deformation of the rechargeable battery

*FIG. 6*

Europäisches
Patentamt

European
Patent Office

Office européen
des brevets

# EUROPEAN SEARCH REPORT

Application Number

EP 23 18 3141

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | WO 2018/057656 A1 (APPLE INC [US]) 29 March 2018 (2018-03-29) | 1,4-6, 12-15 | INV. H02J7/00 |
| A | * paragraphs [0109], [0113], [0114]; figures 3A, 5 * | 2,3,7-11 | H02J50/10 H01M10/44 G01B7/16 |
| Y | US 2018/149462 A1 (GHANTOUS DANIA [US] ET AL) 31 May 2018 (2018-05-31) | 1,4-6, 12-15 | ADD. |
| A | * paragraphs [0009], [0079]; figure 6C * | 2,3,7-11 | H02J50/90 |

TECHNICAL FIELDS
SEARCHED      (IPC)

H02J
H01M
G01B

The present search report has been drawn up for all claims

| Place of search | Date of completion of the search | Examiner |
|---|---|---|
| Munich | 11 January 2024 | Sulic, Tomislav |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 23 18 3141

This annex lists the patent family members relating to the patent documents cited in  the above-mentioned European search report.
The members are as contained in the European Patent Office EDP file on
The European Patent Office is in no way liable for these particulars which are merely given for the purpose of information.

11-01-2024

| Patent document cited in search report | | Publication date | Patent family member(s) | | Publication date |
|---|---|---|---|---|---|
| WO 2018057656 | A1 | 29-03-2018 | CN | 109792166 A | 21-05-2019 |
| | | | CN | 115208079 A | 18-10-2022 |
| | | | KR | 20190032533 A | 27-03-2019 |
| | | | KR | 20210064424 A | 02-06-2021 |
| | | | US | 2019190324 A1 | 20-06-2019 |
| | | | US | 2021359556 A1 | 18-11-2021 |
| | | | WO | 2018057656 A1 | 29-03-2018 |
| US 2018149462 | A1 | 31-05-2018 | CN | 105548889 A | 04-05-2016 |
| | | | US | 2016116548 A1 | 28-04-2016 |
| | | | US | 2018149462 A1 | 31-05-2018 |

EPO FORM P0459

For more details about this annex : see Official Journal of the European Patent Office, No. 12/82